# EUROPEAN PATENT SPECIFICATION

(11) **EP 2 058 858 B1**
(45) Date of publication and mention of the grant of the patent: **05.12.2018**
(21) Application number: 08167663.7
(22) Date of filing: 27.10.2008
(51) Int. Cl.: H01L 23/498

(54) **Silicon interposer and semiconductor device package and semiconductor device incorporating the same and interposer manufacture**
Silizium-Interposer- und Halbleitervorrichtungspaket und Halbleitervorrichtung damit und Interposerherstellung
Interposeur de silicium et emballage de dispositif semiconducteur, et dispositif semiconducteur incorporant celui-ci et fabrication d'interposeur

(30) Priority: 26.10.2007 JP 2007278440
(43) Date of publication of application: 13.05.2009
(73) Proprietor: Shinko Electric Industries Co., Ltd., Nagano-shi, Nagano 381-2287 (JP)
(72) Inventor: Sunohara, Masahiro, Shinko Electric Industries co., Ltd., Nagano-shi, Nagano 381-2287 (JP)
(74) Representative: Zimmermann & Partner Patentanwälte mbB

(56) References cited:
- EP-A2- 1 806 782
- WO-A1-2007/032213
- US-A1- 2006 202 347
- US-A1- 2006 278 331
- CEMAL BASARAN ET AL: "Measuring intrinsic elastic modulus of Pb/Sn solder alloys", MECHANICS OF MATERIALS, vol. 34, no. 6, 1 June 2002 (2002-06-01), pages 349-362, XP055109185, ISSN: 0167-6636, DOI: 10.1016/S0167-6636(02)00131-X
- Dr Thomas Siewert ET AL: "Database for Solder Properties with Emphasis on New Lead-free Solders Properties of Lead-Free Solders Release 4.0", , 11 February 2002 (2002-02-11), XP055109187, Retrieved from the Internet: URL:http://www.msed.nist.gov/solder/NIST_L eadfreeSolder_v4.pdf [retrieved on 2014-03-20]

## Description

The present invention relates to a silicon interposer, a semiconductor device package and a semiconductor device incorporating the silicon interposer. In addition, the present invention also relates to a method for fabricating a silicon interposer.

In the case that a semiconductor device is produced, for example, by mounting semiconductor elements on a wiring board which is made of a glass epoxy material and on which a wiring pattern is formed, by carrying out soldering or the like, it is necessary to heat the wiring board and the semiconductor elements up to the solder melting temperature. At this time, since the thermal expansion coefficient of the wiring board made of a glass epoxy material is different from that of the semiconductor elements made of silicon, cracks may occur at the connection sections between the wiring board and the semiconductor elements and the semiconductor elements may be damaged when the wiring board and the semiconductor elements become cool after the completion of the soldering processing.

For the purpose of solving the above-mentioned problem due to the difference in thermal expansion coefficient between the wiring board and the semiconductor elements, the so-called silicon interposer is known in which a silicon board made of the same material as that of the semiconductor elements is held between the wiring board and the semiconductor elements to make electrical connections between the wiring board and the semiconductor elements while relieving the stress generated owing to the difference in thermal expansion coefficient therebetween.

The semiconductor device disclosed in Patent document 1 is taken as an example of a semiconductor device incorporating such a silicon interposer. Patent document 1 describes a method for forming through-hole electrodes in a silicon board (silicon interposer). More specifically, after through-hole electrodes are formed in a silicon board, a first metal layer is formed on one face side of the silicon board and a protective tape is attached, and the first metal layer is filled into the through-hole electrodes from the other face side of the silicon board by carrying out electrolytic plating while the first metal layer is used as a power feeding layer, and then the first metal layer other than that at the periphery of the through-hole electrodes is removed.
[Patent document 1] JP-A No. 2006-351968
US 2006/202347 A1 describes a through electrode, a package base having a through electrode, and a semiconductor chip having a through electrode. EP 1 806 782 A1 describes a method for manufacturing a semiconductor device.

However, even in a semiconductor device incorporating a silicon interposer, at portions where the copper filled in a through-hole electrode makes direct contact with silicon oxide serving as an insulating film for protecting the wiring layer, the thermal expansion coefficient (18.3 ppm/deg C) of the copper is significantly different from the thermal expansion coefficient (0.4 ppm/deg C) of the silicon oxide, whereby there arises a problem in which cracks occur at these connection sections.

To solve this problem, a method is conceived in which the thermal expansion coefficient of the through-hole electrode is made close to the thermal expansion coefficient of the insulating film to avoid thermal stress at the connection sections. For example, it is conceivable that iron or a nickel alloy is used for the through-hole electrode. However, since iron and a nickel alloy have high electric resistance values and are magnetic materials, there occurs a problem in which the high frequency characteristics of semiconductor devices to be produced are not excellent.

Furthermore, it is also conceivable that the material of the insulating layer connected to the through-hole electrodes is changed. However, since semiconductor devices are strongly requested to be high in density, the insulating film covering the surface of the silicon interposer on the side on which semiconductor elements are mounted must be made of silicon oxide on which a minute wiring pattern can be formed.

Hence, it is not a realistic idea to solve the above-mentioned problem by changing the materials that are used to form the through-hole electrodes and the insulating film.

At least some of the problems in the art are overcome by the silicon interposer according to claims 1, the semiconductor device package according to claim 5, the semiconductor device according to claim 6, and the method for fabricating a silicon interposer according to claim 7. Further aspects, details and advantages are evident from the dependent claims, the description and the accompanying drawings.

To solve the problems, by providing a buffer section for relieving the thermal stress generated owing to the difference in thermal expansion coefficient between through-hole electrodes and an insulating film making contact with the through-hole electrodes, the present invention is intended to provide a silicon interposer not causing cracks between the through-hole electrodes and the insulating film making contact with the through-hole electrodes even if a thermal load is repeatedly applied to a semiconductor device having through-hole electrodes made of copper, and the present invention is also intended to provide a semiconductor device package and a semiconductor device incorporating the silicon interposer.

According to a first aspect of the invention, a silicon interposer according to claim 1 is provided. The silicon interposer is held between a wiring board and semiconductor elements to electrically connect the wiring board to the semiconductor elements. The silicon interposer includes a wafer with a plurality of through-holes.

Through-hole electrodes for electrically connecting the wiring board to the semiconductor elements are formed in the through holes, wherein each of the through-hole electrodes includes a base section and a buffer section.

The buffer section is formed of a conductive material having an elastic coefficient lower than that of the conductive material of the base section.

Each of the through-hole electrodes includes a base section disposed in a portion of the respective through-hole. At least one buffer section completely fills the respective through-hole to form the respective through-hole electrode. The buffer section is flattened.

Further, according to a second aspect of the invention, there is provided the silicon interposer according to the first aspect, wherein
the buffer section is formed in multiple layers.

Further, according to a third aspect of the invention, there is provided the silicon interposer according to the second aspect, wherein
the elastic coefficients of the respective conductive materials of the buffer section are set so that the elastic coefficient on the exposed face side of the through-hole electrode is lower.

With these characteristics, even if there is a great difference between the thermal expansion coefficient of the conductive material of the through-hole electrode on the side of the wiring board and the thermal expansion coefficient of the insulating film, the thermal stress owing to the difference in thermal expansion coefficient can be absorbed. This configuration is advantageous since the number of choices for the conductive material on the side of the semiconductor elements increases.

Further, according to a forth aspect of the invention, there is provided the silicon interposer according to any one of the first to third aspects, wherein
the buffer section is provided on a side on which the semiconductor elements are mounted.

Since the wiring pattern on the side on which the semiconductor elements are mounted is minute and is significantly affected owing to the thermal stress around the through-hole electrodes, the configuration capable of relieving the thermal stress can be used particularly favorably.

Further, according to the invention,
the conductive material of the buffer section is made of one of solder.

Hence, at the connection section between the through-hole electrode and the insulating film, the stress concentration generated owing to the difference in thermal expansion amount (thermal shrinkage amount) between the conductive material filled in the through-hole electrode and the insulating film is relieved, and cracks can be prevented from occurring at the connection section between the through-hole electrode and the insulating film.

Further, according to a further aspect of the invention, there is provided the silicon interposer according to any one of the first to fourth aspects, wherein
the buffer section is formed by the electrolytic plating method.

Further, according to a further aspect of the invention, there is provided the silicon interposer according to any one of the first to fifth aspects, wherein
the buffer section is formed by the paste injection method.

Hence, the conventional technologies can be applied, and processing is made possible at low cost.

Further, according to the invention, the buffer section is formed to have a height in the range of 10 to 20% of the height of the through-hole electrode.

Hence, this characteristic is advantageous since the thermal stress at the connection section between the through-hole electrode and the insulating film can be relieved while the electrical characteristics at the connection section between the through-hole electrode and the insulating film is prevented from lowering.

Further, according to a fifth aspect of the invention, there is provided a semiconductor device package including:
the silicon interposer according to any one of the first to eighth aspects, and
a wiring board electrically connected to the silicon interposer.

Further, according to a sixth aspect of the invention, there is provided a semiconductor device including:
semiconductor elements,
a wiring board electrically connected to the semiconductor elements, and
the silicon interposer according to any one of the first to fifth aspects held therebetween.

With these configurations, even if a thermal load is applied repeatedly, the thermal stress between the through-hole electrode and the insulating film is relieved, and the reliability of the electrical connection between the through-hole electrode and the insulating film can be improved remarkably.

Further, according to yet another aspect, there is provided a silicon interposer being held between a wiring board and a semiconductor element to electrically connect the wiring board to the semiconductor element, wherein through-hole electrodes for electrically connecting the wiring board to the semiconductor elements are each formed of a base section and a buffer section, and the buffer section is formed of a conductive material having an elastic coefficient lower than that of the conductive material of the base section, and a semiconductor device package and a semiconductor device incorporating the silicon interposer.

Further, according to yet another aspect, there is provided a method for fabricating a silicon interposer according to claim 7. The silicon interposer is adapted for being held between a wiring board and semiconductor elements and to electrically connect the wiring board to the semiconductor elements. The method includes: providing a silicon wafer, forming a plurality of through-holes in the silicon wafer, fabricating a through-hole electrode in the respective through-holes, the through-electrode is adapted for electrically connecting the wiring board to the semiconductor elements, forming a base section of a first conductive material in the respective through-hole electrode, and forming at least one buffer section of a second conductive material so that each through-hole is completely filled and the buffer section flattened, the second conductive material having an elastic coefficient lower than that of the first conductive material. Conductive material of the at least one buffer section is made of solder, and the at least one buffer section is formed to have a height in the range of 10 to 20% of the 10 height of the through-hole electrode

With the silicon interposer and the semiconductor device package and the semiconductor device incorporating the silicon interposer according to the present invention, since the buffer section disposed at the connection section between the through-hole electrode and the insulating film acts as a cushion layer even if a thermal load is repeatedly applied to the semiconductor device, the present invention can provide a silicon interposer not causing cracks owing to the difference in thermal expansion coefficient (thermal expansion amount and thermal shrinkage amount) between the through-hole electrode and the insulating film at the connection section between the through-hole electrode and the insulating film, and the present invention can also provide a semiconductor device package and a semiconductor device incorporating the silicon interposer.

Embodiments of the present disclosure will be described with respect to the accompanying drawings in more detail in the following.
FIGS. 1A to 1D are sectional views showing the states at the periphery of the through-hole electrodes in the respective production stages of a silicon interposer according to a first embodiment;
FIGS. 2A to 2D are sectional views showing the states at the periphery of the through-hole electrodes in the respective production stages of the silicon interposer according to the first embodiment;
FIGS. 3A to 3D are sectional views showing the states at the periphery of the through-hole electrodes in the respective production stages of the silicon interposer according to the first embodiment;
FIGS. 4A to 4D are sectional views showing the states at the periphery of the through-hole electrodes in the respective production stages of the silicon interposer according to the first embodiment;
FIGS. 5A and 5B are sectional views showing the states at the periphery of the through-hole electrodes in the respective production stages of the silicon interposer according to the first embodiment;
FIG. 6 is a sectional view showing the state at the periphery of the through-hole electrodes of the silicon interposer according to the first embodiment;
FIG. 7 is a sectional view showing the state at the periphery of the through-hole electrodes of a semiconductor device package according to the first embodiment;
FIG. 8 is a sectional view showing the state at the periphery of the through-hole electrodes of a semiconductor device according to the first embodiment;
FIG. 9 is a sectional view showing the state at the periphery of the through-hole electrodes of a silicon interposer according to a second embodiment; and
FIG. 10 is a sectional view showing the state at the periphery of the through-hole electrodes of a silicon interposer according to a third embodiment.

### (First embodiment)

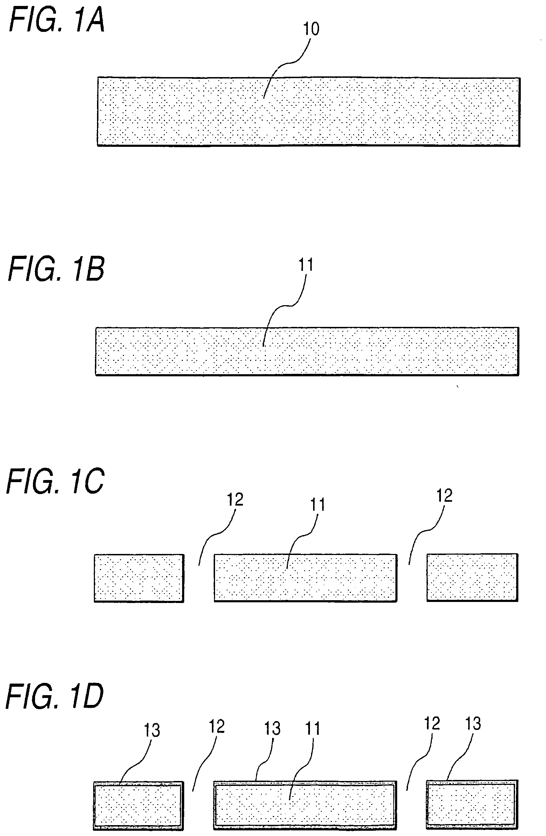

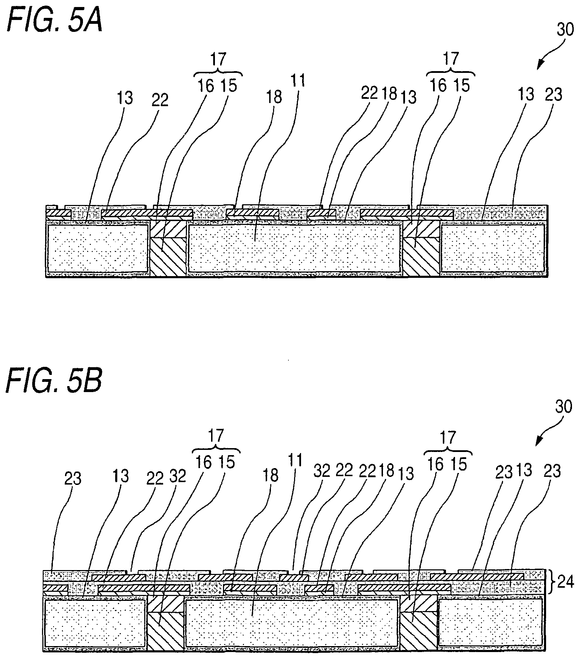

An embodiment of a silicon interposer according to the present invention will be described below on the basis of the drawings. FIGS. 1A to 1D and FIGS. 5A and 5B are sectional views showing the states at the periphery of through-hole electrodes in the respective production stages of the silicon interposer according to this embodiment.

First, as shown in FIG. 1A, after a silicon wafer 10 is sliced, it is ground using a grinder or the like to a thickness of 300 µm. After the silicon wafer 10 is processed into a thin silicon wafer 11 shown in FIG. 1B, the surface of the thin silicon wafer 11 is covered with a mask having openings at regions where through holes 12 are formed, and etching is carried out, whereby the through holes 12 shown in FIG. 1C are formed. The through holes 12 according to this embodiment are formed so as to have a diameter of 60 µm. The through holes 12 are later filled with conductive materials so as to be formed into the through-hole electrodes 17 of a silicon interposer 30.

The thin silicon wafer 11 is then subjected to thermal oxidation processing to form a silicon oxide coating 13 on the outer surface of the thin silicon wafer 11 as shown in FIG. 1D. In this embodiment, the thin silicon wafer 11 is subjected to thermal oxidation processing for 6 hours at 1000 deg C inside an oxygen furnace. The thickness of the silicon oxide coating 13 formed in this way is approximately 1.5 µm.

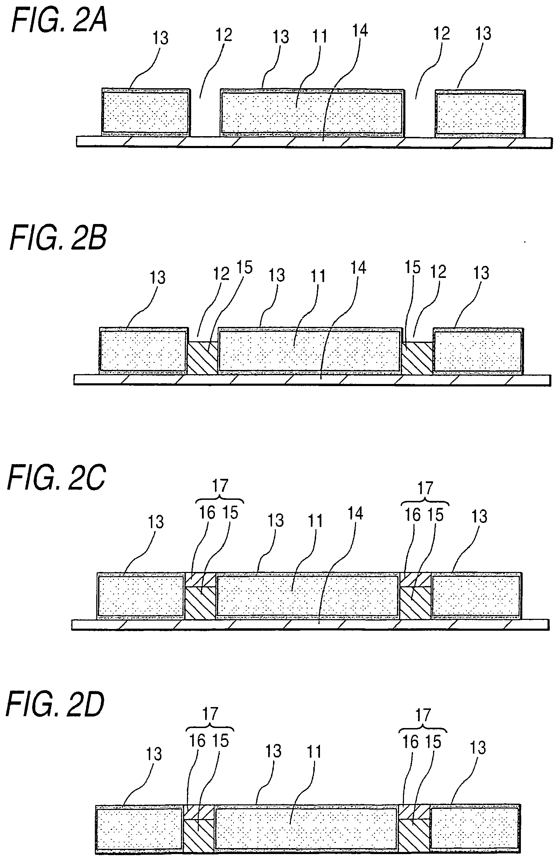

After the silicon oxide coating 13 is formed on the thin silicon wafer 11, a metal film 14, such as a copper film, is bonded to one face of the thin silicon wafer 11 as shown in FIG. 2A, and electrolytic copper plating is carried out while this metal film 14 is used as a power feeding layer, whereby copper 15 serving as a base section is filled into the through hole 12 up to a desired level. The level of the upper end face of the copper 15 filled into the through hole 12 is preferably 80 to 90% of the height (depth) of the through hole 12. The metal film 14 can be used as a power feeding layer when electrolytic plating is carried out and should only be formed to have a thickness capable of supporting the conductive materials filled into the through hole 12.

After the base section is formed by filling (depositing) the copper 15 into the through hole 12 up to a halfway depth position thereof, the thin silicon wafer 11 is moved to a plating solution bath wherein solder is deposited, and the through hole 12 is subjected to electrolytic solder plating. In other words, solder 16 serving as a buffer section is filled on the copper 15 as shown in FIG. 2C so that the solder 16 serving as the buffer section is overlaid on the copper 15 serving as the base section, whereby a through-hole electrode 17 is completed.

The through-hole electrode 17 formed by the multi-layer plating method as described above is formed of multiple kinds of conductive materials. The present invention is characterized in that it uses the conductive material (the solder 16 in this embodiment) of the buffer section constituting the through-hole electrode 17, having an elastic coefficient sufficiently lower than the elastic coefficient of the conductive material (the copper 15 in this embodiment) of the base section.

The height of the buffer section (the solder 16) is in the range of 10 to 20% of the height (the thickness of the thin silicon wafer 11) of the through hole 12. In this embodiment, the deposition height of the solder 16 is assumed to be 50 µm.

After the through-hole electrodes 17 are formed, the metal film 14 having been used as the power feeding layer is removed as shown in FIG. 2D. In the case that the surface of the solder 16 is not flattened, the surface of the solder 16 serving as the exposed faces of the through-hole electrodes 17 is subjected to flattening processing as necessary.

In the desired range on one of the upper and lower exposed faces of the through-hole electrode 17 formed as described above according to this embodiment, on which semiconductor elements formed of silicon are mounted, the conductive material (the solder 16), the elastic coefficient of which is lower than that of the conductive material (the copper 15) serving as the base section and filled on the side making contact with a wiring board, is filled. Hence, the difference between the thermal expansion coefficient (thermal expansion amount and thermal shrinkage amount) of an insulating film 23 formed of silicon oxide and described later and the thermal expansion coefficient (thermal expansion amount and thermal shrinkage amount, hereafter, sometimes simply referred as thermal expansion coefficient) of the copper 15 is absorbed by the elastic deformation of the solder 16, and the solder 16 acts as a buffer section for relieving the thermal stress generated between the insulating film 23 and the through-hole electrode 17.

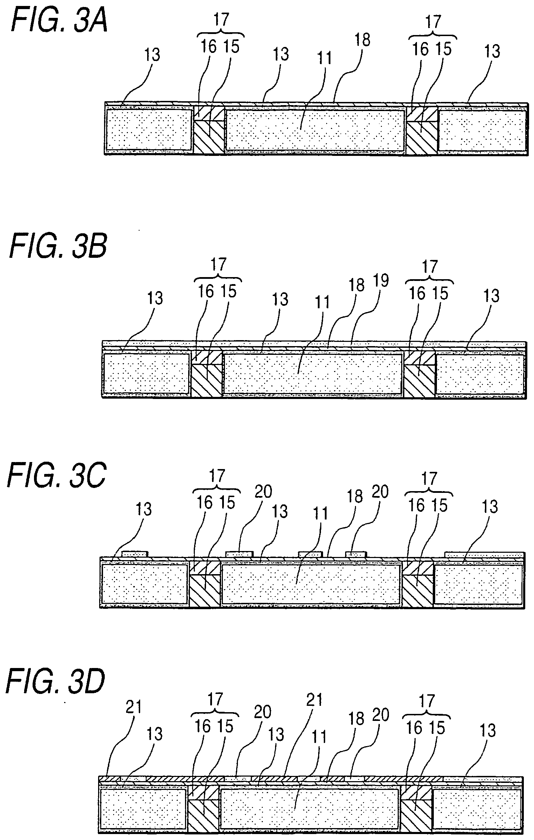

Next, as shown in FIG. 3A, a seed layer (plated seed layer) 18 made of titanium or chromium is formed by sputtering or the like on the semiconductor element mounting face (the face on the side of the through-hole electrode 17 filled with the solder 16) of the thin silicon wafer 11. In this embodiment, the plated seed layer 18 is formed by forming a titanium sputter film of 100 nm and than by overlaying a copper sputter film of 300 nm on the titanium sputter film. In the figure, the titanium sputter film and the copper sputter film are shown in an integrated state.

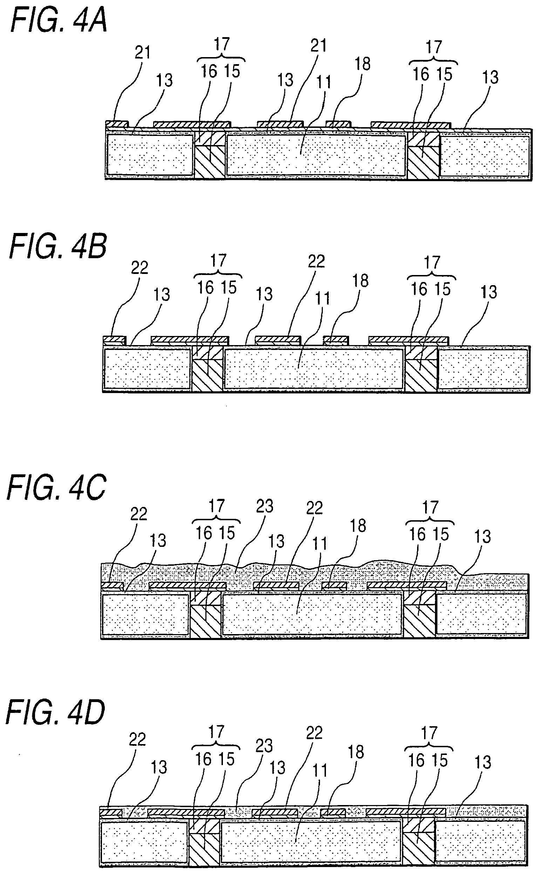

A solder resist 19 is coated as shown in FIG. 3B on the plated seed layer 18 formed as described above, and the solder resist 19 is subjected to exposure and development to form a resist pattern 20 shown in FIG. 3C. After the resist pattern 20 is formed, electrolytic copper plating is carried out to form a conductor layer 21 as shown in FIG. 3D. The conductor layer 21 according to this embodiment is formed so as to have a thickness of 3 µm. After the conductor layer 21 is formed, the resist pattern 20 is removed by carrying out etching as shown in FIG. 4A. Then, the plated seed layer 18 covered with the resist pattern 20 is selectively removed to form a wiring pattern 22 from which the conductor layer 21 is made independent as shown in FIG. 4B.

Next, as shown in FIG. 4C, the surface of the wiring pattern 22 is covered with the insulating film 23 formed of a silicon oxide film. In this embodiment, the silicon oxide film is formed using the low-temperature CVD method at approximately 200 deg C. After the insulating film 23 is formed, the upper face of the insulating film 23 is ground and flattened as shown in FIG. 4D. In this embodiment, the insulating film 23 on the wiring pattern 22 is flattened so as to have a thickness of 1 µm.

Next, as shown in FIG. 5A, the insulating film 23 is partially removed by etching so that part of the wiring pattern 22 is exposed outside so as to serve as connection pads 32, whereby a silicon interposer 30 is formed. RIE (reactive ion etching) is applied as the etching method for the insulating film 23 according to this embodiment.

Furthermore, as shown in FIG. 5B, a multi-layer wiring 24 can be formed as necessary on the upper face side of the silicon interposer 30 (on the side on which semiconductor elements are mounted). The wiring pattern of the upper layer can be formed by conducting a procedure in which a silicon oxide film is used as the insulating film 23, a plated seed layer is formed using a method similar to the above-mentioned method, a solder resist is coated on the plated seed layer, and exposure and development are carried out to form a resist pattern, and then electrolytic plating is carried out to form a conductor layer.

It is advantageous to use a silicon oxide film as the insulating film 23 because the insulating film 23 between the layers can be flattened and high density due to formation of minute wiring can be attained.

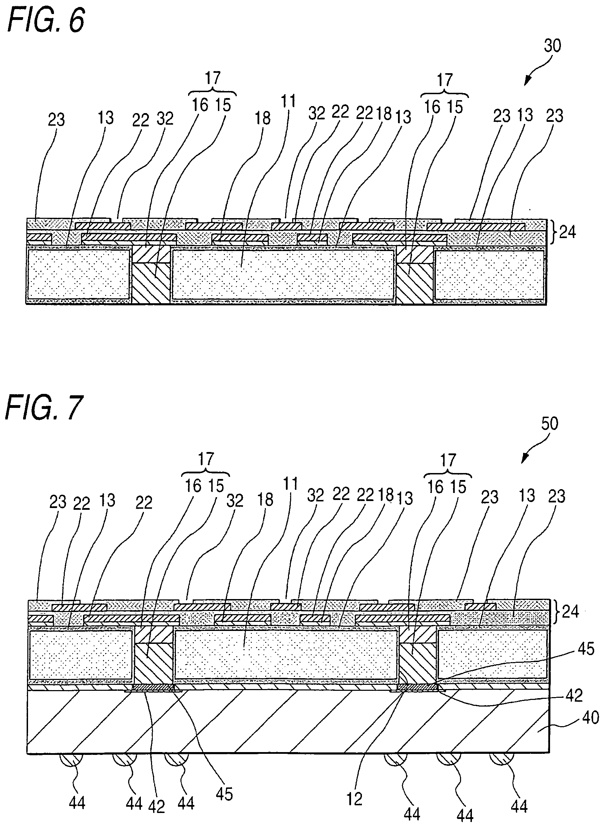

FIG. 6 is a sectional view showing the configuration at the periphery of the through-hole electrodes of the silicon interposer according to this embodiment. As shown in FIG. 6, the through holes 12 passing through the thin silicon wafer 11 in the thickness direction thereof are formed in the silicon interposer 30 according to this embodiment, and the oxide coating 13 is formed on the entire surface of the thin silicon wafer 11 including the inner wall faces of the through holes 12. The through hole 12 is formed into the through-hole electrode 17 by filling the copper 15 serving as the conductive material of the base section and the solder 16 serving as the conductive material of the buffer section into the through hole 12 in the state in which the copper 15 and the solder 16 are overlaid in this order. The side (the side of the base section) in which the copper 15 is filled is the side of the wiring board, and the side (the side of the buffer section) in which the solder 16 is filled is the side of the semiconductor element.

In the through-hole electrode 17, on the side of the thin silicon wafer 11 in which the solder 16 is filled, the plated seed layer 18 is formed on the oxide coating 13, and the multiple layers of the wiring pattern 22 and the insulating film 23 are provided using the semi-additive method, whereby the multi-layer wiring 24 is formed. On the upper surface of the multi-layer wiring 24, part of the wiring pattern 22 is exposed outside by etching to form the connection pads 32 of the silicon interposer 30.

Even if a difference occurs between the thermal expansion amount (thermal shrinkage amount) of the copper 15 filled in the through-hole electrode 17 and the thermal expansion amount (thermal shrinkage amount) of the silicon oxide film forming the insulating film 23 in the processing in which the silicon interposer 30 having the above-mentioned configuration is heated to the solder melting temperature at the time of connecting the silicon interposer to a semiconductor device 60 as described later and then cooled to room temperature, the thermal stress generated owing to the difference in thermal expansion amount (thermal shrinkage amount) is absorbed since the solder 16 filled in the upper portion deforms resiliently. In other words, the stress concentration at the periphery of the connection section on the upper face of the through-hole electrode 17 is relieved. Since the solder 16 inside the through-hole electrode 17 acts as the buffer section (cushion section) for the thermal stress, a problem in which cracks occur between the through-hole electrode 17 and the insulating film 23 owing to the thermal stress can be avoided, whereby this configuration is effective since the reliability of the silicon interposer 30 with respect to the electrical connection is improved.

In the silicon interposer 30 formed as described above, to the side of the lower faces (the side of the face to which the metal film 14 is bonded) of the through-hole electrodes 17, a wiring board 40, such as a build-up board, in which connection pads 42 and external connection terminals 44 are formed and solder 45 is applied to the connection pads 42, is connected electrically, whereby a semiconductor device package 50 shown in FIG. 7 can be obtained.

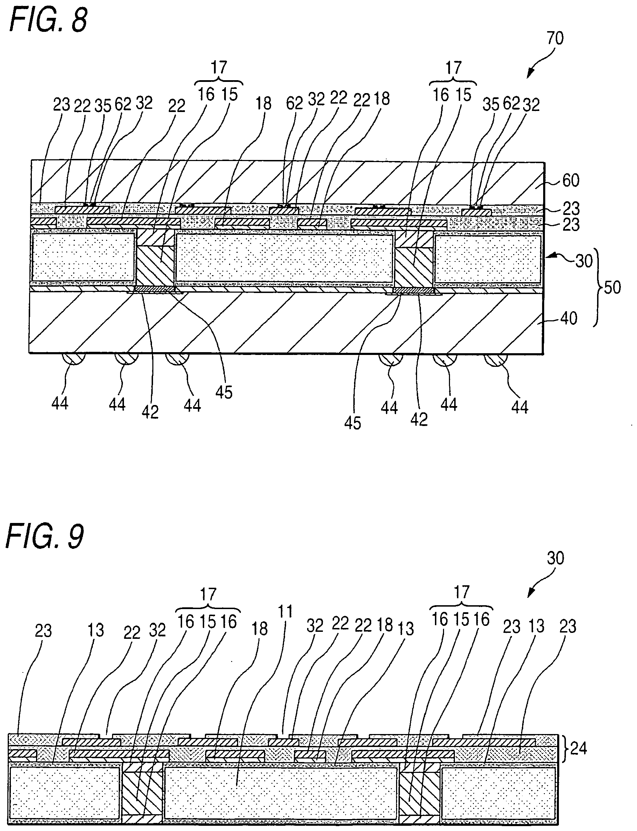

Furthermore, solder 35 is applied to the connection pads 32 formed on the surface of the multi-layer wiring 24 on the upper face of the semiconductor device package 50 shown in FIG. 7, and a semiconductor element 60 in which electrodes 62, such as gold bumps, are formed is mounted on the connection pads 32. The semiconductor element 60 is then electrically connected to the semiconductor device package 50, whereby the semiconductor device 70 shown in FIG. 8 can be obtained.

Moreover, it is possible that the semiconductor device 70 is mounted on a mother board or the like not shown in the figure via the external connection terminals 44 and that they are electrically connected to each other.

In the semiconductor device 70 formed as described above, the thermal expansion amount (thermal shrinkage amount) of the semiconductor element 60 can be matched with that of the silicon interposer 30. Hence, even if the silicon interposer 30 is heated to the solder melting temperature to connect the connection pads 32 of the silicon interposer 30 to the electrodes 62 of the semiconductor element 60 and then cooled to room temperature, since the thermal expansion amount and the thermal shrinkage amount are very small, there is no danger of damaging the semiconductor element 60. Furthermore, since the through-hole electrode 17 is provided with the buffer section acting as a cushion section for absorbing the thermal stress generated around the through-hole electrode 17 owing to the difference in thermal expansion coefficient, the stress generated owing to the difference in thermal expansion coefficient between the copper 15 inside the through-hole electrode 17 and the insulating film 23 formed on the upper face of the silicon interposer 30 is absorbed by the elastic deformation of the cushion layer (the solder 16). As a result, cracks at the periphery of the through-hole electrode 17 can be prevented securely.

Hence, the semiconductor device 70 can have very high reliability.

### (Second embodiment)

In the first embodiment, since the upper face side of the silicon interposer 30 in the figure is used as a face on which the semiconductor element 60 is mounted, the solder 16 serving as the buffer section for thermal stress is filled in a desired range on the copper 15 serving as the base section and filled in the through-hole electrode 17. However, the present invention is not limited to this configuration.

The present invention relates to a structure in which the buffer section for absorbing the thermal stress generated at the portion connected to the through-hole electrode 17 and having a thermal expansion coefficient significantly different from the thermal expansion coefficient of the base section (the copper 15) of the through-hole electrode 17 is provided between the base section (the copper 15) inside the through-hole electrode 17 and the connection sections of the through-hole electrode 17. Hence, even if the wiring board 40 is on the side on which the connection is carried out as in the embodiment described earlier, in the case that the connection pads 42 of the wiring board 40 are formed at high density, for example, the present invention can be applied favorably.

FIG. 9 is a sectional view showing the structure at the periphery of the through-hole electrodes of a silicon interposer according to the second embodiment.

As shown in FIG. 9, the silicon interposer 30 according to this embodiment is characterized in that the buffer sections (the solder 16) are exposed on the upper and lower exposed faces of the through-hole electrode 17 and that the base section (the copper 15) is filled between the buffer sections (the solder 16). Components other than those of the silicon interposer 30 according to this embodiment are designated by the numerals used for the descriptions of the silicon interposer 30 according to the first embodiment, and their detailed descriptions are omitted herein.

With the silicon interposer 30 according to this embodiment, in the case that the semiconductor element 60 and the wiring board 40 are mounted on both the upper and lower faces of the silicon interposer 30 and they are electrically connected via the through-hole electrodes 17, the thermal stress generated around the through-hole electrodes 17 can be absorbed using the solder 16 serving as the buffer sections. Hence, a semiconductor device package 50 and a semiconductor device 70 having high reliability can be provided by using the silicon interposer 30 having this structure.

### (Third embodiment)

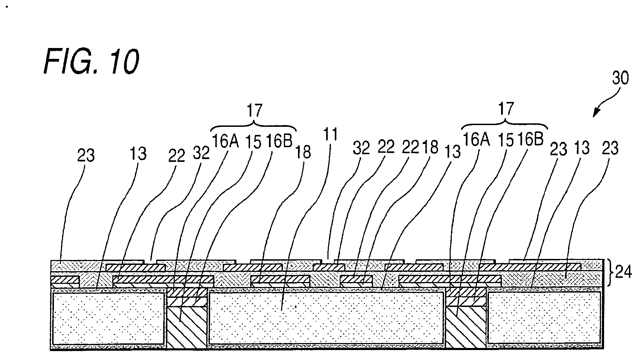

FIG. 10 is a sectional view showing the structure at the periphery of the through-hole electrodes of a silicon interposer according to a third embodiment. This embodiment is characterized in that the conductive materials filled in the buffer section of the through-hole electrode 17 are formed of conductive materials 16A and 16B that are different from each other and overlaid. In the case of this structure, it is preferable that the conductive materials 16A and 16B constituting the buffer section should be overlaid such that the elastic coefficient of the buffer section lowers gradually toward the exposed face of the through-hole electrode 17.

By virtue of the adoption of the configuration of the silicon interposer 30 according to this embodiment, the gradient (the gradient of elastic coefficient) of the deformation amount in the range of the buffer section to the base section inside the through-hole electrode 17 becomes moderate, and the reliability of the through-hole electrode 17 itself can be improved. Furthermore, this configuration is desirable since the number of choices for the conductive materials 16A and 16B used for the buffer section increases.

Components other than those of the silicon interposer 30 according to this embodiment are also designated by the numerals used for the descriptions of the silicon interposer 30 according to the first embodiment, and their detailed descriptions are omitted herein.

The configuration of the through-hole electrode 17 shown in FIG. 10 can also be applied to that of the through-hole electrode 17 according to the second embodiment as a matter of course.

Although the silicon interposer 30 and the semiconductor device package 50 and the semiconductor device 70 incorporating the silicon interposer 30 according to the embodiments of the present invention are described above, the present invention is not limited to the embodiments described above, and other embodiments may also be made within the technical scope of the present invention as a matter of course.

For example, in the embodiments, the electrolytic plating method is used when the conductive materials are deposited (filled) into the through-hole 12. However, it may also be possible that the electrolytic plating method is used when the conductive material on the side to which the metal film 14 is bonded is filled, and that a conductive paste containing minute particles of a conductive material (a conductive material having an elastic coefficient lower than that of the conductive material being filled previously) is filled in the through hole 12 using the printing method on the side on which the semiconductor element is mounted. It is advantageous to use the printing method on the side of the opening end of the through hole 12 as described above because the step for flattening the through-hole electrode 17 can be omitted.

Moreover, although the solder 16 is taken as an example of the conductive material for use in the buffer section in the above-mentioned embodiments, the so-called low-elasticity conductive materials, typified by indium, tin, bismuth and gold, can be used for the buffer section, in addition to the solder 16.

## Claims

1. A silicon interposer (30) for being held between a wiring board (40) and semiconductor elements to electrically connect the wiring board (40) to the semiconductor elements, comprising:
a silicon wafer (11) with a plurality of through-holes (12);
through-hole electrodes (17) formed in each of the plurality of through-holes (12) for electrically connecting the wiring board (40) to the semiconductor elements, each of the through-hole electrodes (17) includes a base section (15) disposed in a portion of each of the plurality of through-holes (12), and at least one buffer section (16) completely filling each of the plurality of through-holes (12) to form each of the through-hole electrodes (17), the buffer section (16) being flattened, wherein
the at least one buffer section is formed of a conductive material having a Young's modulus lower than that of the conductive material of the base section, wherein the conductive material of the at least one buffer section is made of solder, and the at least one buffer section is formed to have a height in the range of 10 to 20% of the height of the through-hole electrode.

2. The silicon interposer according to claim 1, wherein
the at least one buffer section is formed in multiple layers.

3. The silicon interposer according to any of the preceding claims, wherein
the Young's moduli of the respective conductive materials of the at least one buffer section are set so that the Young's modulus on the exposed face side of the through-hole electrode is lower.

4. The silicon interposer according to any of the preceding claims, wherein
the at least one buffer section is provided on a side on which the at least one semiconductor element is mounted.

5. A semiconductor device package comprising:
the silicon interposer according to any of claims 1 to 4, and
a wiring board electrically connected to the silicon interposer.

6. A semiconductor device comprising:
semiconductor elements,
a wiring board electrically connected to the semiconductor elements, and
the silicon interposer according to any of claims 1 to 4 held therebetween.

7. A method for fabricating a silicon interposer, the silicon interposer adapted for being held between a wiring board (40) and semiconductor elements (60) and to electrically connect the wiring board (40) to the semiconductor elements (60), the method comprising:
providing a silicon wafer (11),
forming a plurality of through-holes (12) in the silicon wafer (11),
fabricating a through-hole electrode (17) in each of the plurality of through-holes (12), the through-hole electrodes (17) being adapted for electrically connecting the wiring board (40) to the semiconductor elements (60), including:
forming a base section (15) of a first conductive material in each of the plurality of through-holes (12), and
forming at least one buffer section (16) of a second conductive material so that each of the plurality of through-holes (12) is completely filled and that the at least one buffer section (16) is flattened, the second conductive material having a Young's modulus lower than that of the first conductive material, wherein the conductive material of the at least one buffer section is made of solder, and the at least one buffer section is formed to have a height in the range of 10 to 20% of the height of the through-hole electrode.

## Patentansprüche

1. Silizium-Interposer (30) zum Anbringen zwischen einer Leiterplatte (40) und Halbleiterelementen zur elektrischen Verbindung der Leiterplatte (40) mit den Halbleiterelementen, umfassend:
ein Siliziumwafer (11) mit einer Mehrzahl von Durchgangslöchern (12);
Durchgangslochelektroden (17), die in jedem der Mehrzahl von Durchgangslöchern (12) zur elektrischen Verbindung der Leiterplatte (40) mit den Halbleiterelementen gebildet sind, wobei jede der Durchgangslochelektroden (17) einen Basisabschnitt (15), der an einem Teil jeder der Mehrzahl von Durchgangslöchern (12) angeordnet ist, und wenigstens einen Pufferabschnitt (16), umfasst, der jede der Mehrzahl von Durchgangslöchern (12) vollständig füllt, um jede der Durchgangslochelektroden (17) zu bilden, wobei der Pufferabschnitt (16) abgeflacht ist, wobei
der wenigstens eine Pufferabschnitt aus einem leitenden Material mit einem Elastizitätsmodul hergestellt ist, das niedriger ist als das des leitenden Materials des Basisabschnitts, wobei das leitende Material des wenigstens einen Puffabschnitts aus Lot hergestellt ist, und der wenigstens eine Pufferabschnitt derart ausgebildet ist, dass er eine Höhe in dem Bereich von 10 bis 20 % der Höhe der Durchgangslochelektrode hat.

2. Silizium-Interposer nach Anspruch 1, wobei der wenigstens eine Pufferabschnitt in mehreren Schichten gebildet ist.

3. Silizium-Interposer nach einem der vorhergehenden Ansprüche, wobei
die Elastizitätsmodule der jeweiligen leitenden Materialien des wenigstens einen Pufferabschnitts so eingestellt sind, dass das Elastizitätsmodul an der exponierten Stirnseite der Durchgangslochelektrode niedriger ist.

4. Silizium-Interposer nach einem der vorhergehenden Ansprüche, wobei
der wenigstens eine Pufferabschnitt auf einer Seite bereitgestellt ist, auf der das wenigstens eine Halbleiterelement montiert ist.

5. Halbleiterpackung, umfassend:
den Silizium-Interposer nach einem der Ansprüche 1 bis 4, und
eine mit dem Silizium-Interposer elektrisch verbundene Leiterplatte.

6. Halbleiteranordnung, umfassend
Halbleiterelemente,
eine mit den Halbleiterelementen elektrisch verbundene Leiterplatte, und
den dazwischen angebrachten Silizium-Interposer nach einem der Ansprüche 1 bis 4.

7. Verfahren zur Herstellung eines Silizium-Interposers, wobei der Silizium-Interposer ausgebildet ist, um zwischen einer Leiterplatte (40) und Halbleiterelementen (60) angebracht zu werden, und die Leiterplatte (40) mit den Halbleiterelementen (60) elektrisch zu verbinden, wobei das Verfahren Folgendes umfasst:
Bereitstellen eines Siliziumwafers (11),
Herstellen einer Mehrzahl von Durchgangslöchern (12) in dem Siliziumwafer (11),
Herstellen einer Durchgangslochelektrode (17) in jeder der Mehrzahl von Durchgangslöchern (12), wobei die Durchgangslochelektroden (17) ausgebildet sind, um die Leiterplatte (40) mit den Halbleiterelementen (60) elektrisch zu verbinden,
einschließlich:
Herstellen eines Basisabschnitts (15) eines ersten leitenden Materials in jeder der Mehrzahl von Durchgangslöchern (12), und
Herstellen von wenigstens einem Pufferabschnitt (16) eines zweiten leitenden Materials, so dass jede der Mehrzahl von Durchgangslöchern (12) vollständig gefüllt ist, und dass der wenigstens eine Pufferabschnitt (16) abgeflacht ist, wobei das zweite leitende Material ein Elastizitätsmodul besitzt, das niedriger ist als das des ersten leitenden Materials, wobei das leitende Material des wenigstens einen Pufferabschnitts aus Lot hergestellt ist, und der wenigstens eine Pufferabschnitt derart ausgebildet ist, dass er eine Höhe in dem Bereich von 10 bis 20 % der Höhe der Durchgangslochelektrode besitzt.

## Revendications

1. Interposeur de silicium (30) destiné à être maintenu entre une carte de câblage (40) et des éléments semi-conducteurs afin de relier électriquement la carte de câblage (40) aux éléments semi-conducteurs, comprenant :
une tranche de silicium (11) avec une pluralité d'orifices traversants (12) ;
des électrodes à orifices traversants (17) formées dans chacun de la pluralité d'orifices traversants (12) afin de relier électriquement la carte de câblage (40) aux éléments semi-conducteurs, chacune des électrodes à orifices traversants (17) comprenant une section de base (15) disposée dans une partie de chacun de la pluralité d'orifices traversants (12), et au moins une section de tampon (16) qui remplit complètement chacun de la pluralité d'orifices traversants (12) afin de former chacune des électrodes à orifices traversants (17), la section de tampon (16) étant aplatie, dans lequel
la au moins une section de tampon est formée d'un matériau conducteur ayant un module de Young inférieur à celui du matériau conducteur de la section de base, dans lequel le matériau conducteur de la au moins une section de tampon est composé de brasure, et la au moins une section de tampon est formée pour avoir une hauteur de l'ordre de 10 à 20% de la hauteur de l'électrode à orifices traversants.

2. Interposeur de silicium selon la revendication 1, dans lequel la au moins une section de tampon est formée dans plusieurs couches.

3. Interposeur de silicium selon l'une quelconque des revendications précédentes, dans lequel
les modules de Young des matériaux conducteurs respectifs de la au moins une section de tampon sont définis de sorte que le module de Young côté face exposée de l'électrode à orifices traversants soit moins élevé.

4. Interposeur de silicium selon l'une quelconque des revendications précédentes, dans lequel
la au moins une section de tampon est prévue sur un côté sur lequel le au moins un élément semi-conducteur est monté.

5. Dispositif semi-conducteur comprenant :
l'interposeur de silicium selon l'une quelconque des revendications 1 à 4, et
une carte de câblage électriquement reliée à l'interposeur de silicium.

6. Dispositif semi-conducteur comprenant :
des éléments semi-conducteurs,
une carte de câblage électriquement reliée aux éléments semi-conducteurs, et
l'interposeur de silicium selon l'une quelconque des revendications 1 à 4 maintenu entre eux.

7. Procédé de fabrication d'un interposeur de silicium, l'interposeur de silicium étant adapté pour être maintenu entre une carte de câblage (40) et des éléments semi-conducteurs (60) et pour relier électriquement la carte de câblage (40) aux éléments semi-conducteurs (60), le procédé comprenant :
le fait de prévoir une tranche de silicium (11),
la formation d'une pluralité d'orifices traversants (12) dans la tranche de silicium (11),
la fabrication d'une électrode à orifices traversants (17) dans chacun de la pluralité d'orifices traversants (12), les électrodes à orifices traversants (17) étant adaptées pour relier électriquement la carte de câblage (40) aux éléments semi-conducteurs (60), comprenant :
la formation d'une section de base (15) d'un premier matériau conducteur dans chacun de la pluralité d'orifices traversants (12), et
la formation d'au moins une section de tampon (16) d'un second matériau conducteur de sorte que chacun de la pluralité d'orifices traversants (12) soit complètement rempli et que la au moins une section de tampon (16) soit aplatie, le second matériau conducteur ayant un module de Young inférieur à celui du premier matériau conducteur, dans lequel le matériau conducteur de la au moins une section de tampon est composé d'une brasure, et la au moins une section de tampon est formée pour avoir une hauteur de l'ordre de 10 à 20% de la hauteur de l'électrode à orifices traversants.
